**Europäisches Patentamt**

**European Patent Office**

**Office européen des brevets**

(19)

(11) Veröffentlichungsnummer: **0 044 935**
A1

# EUROPÄISCHE PATENTANMELDUNG

(12)

(21) Anmeldenummer: 81104592.1

(22) Anmeldetag: 15.06.81

(51) Int. Cl.³: **C 08 L 65/00,** H 01 B 1/12, H 01 L 31/02

(30) Priorität: 11.07.80 DE 3026328

(43) Veröffentlichungstag der Anmeldung: 03.02.82 Patentblatt 82/5

(84) Benannte Vertragsstaaten: **BE DE FR GB NL**

(71) Anmelder: **BASF Aktiengesellschaft, Carl-Bosch-Strasse 38, D-6700 Ludwigshafen (DE)**

(72) Erfinder: **Muench, Volker, Dr., Luitpoldstrasse 114, D-6700 Ludwigshafen (DE)**
Erfinder: **Naarmann, Herbert, Dr., Haardtblick 15, D-6719 Wattenheim (DE)**
Erfinder: **Penzien, Klaus, Dr., Bensheimer Ring 18, D-6710 Frankenthal (DE)**

(54) **Verfahren zur Herstellung von elektrisch leitfähigen Polymeren und deren Verwendung.**

(57) Die Erfindung betrifft ein Verfahren zur Herstellung von elektrisch leitfähigen Polymeren mit elektrischen Leitfähigkeitswerten größer als $10^{-2}$ S/cm, wobei man organischen Polymeren aus der Reihe der Polyphenylene, Heteropolyphenylene oder vorzugsweise Polyacetylene unter Ausschluß von Wasserfeuchtigkeit und von Sauerstoff 0,1 bis 95 Gew.-% schwarzen Phosphor und 0,5 bis 25 Gew.-%. einer starken Lewis-Säure mit $pk_2$-Werten von −10 bis +4 zusetzt. Bevorzugt als Lewis-Säure sind die Verbindungen $AsF_5$, $SbF_5$, $UF_6$, $SbCl_5$, $AlCl_3$, $BF_3$, $CF_3SO_3H$, $VOCl_3$, $HClO_4$, $NO^+SbF_6$, $NO_2^+SbF_6^-$, $NO^+AsF_6$, $NO^+PF_6^-$, $J_2$, $Br_2$, $JCl$, $PF_5$, $CrO_2Cl_2$, $NO_2^+Pf_6^-$, $NO^+BF_4^-$, $NO^+ClO_4^-$, $(CF_3)_2SO_4$, $NbF_5$, $TaF_5$, $WF_6$, $FeCl_3$, $CdCl_2$, 2,4,6-Trinitrophenol, 2,4,6-Trinitrophenylsulfonsäure oder 2,4,6-Trinitrophenylcarbonsäure. Die hergestellten, elektrisch leitfähigen Polymeren können in der Elektrotechnik zur Herstellung von Sonnenzellen, zur Umwandlung und Fixierung von Strahlung, zur Herstellung elektrischer und magnetischer Schalter und zur antistatischen Ausrüstung von Kunststoffen verwendet werden.

0044935

O.Z.0050/034549

BASF Aktiengesellschaft    TITLE MODIFIED
see front page

Verfahren zur Herstellung von elektrisch leitfähigen
polymeren Systemen und deren Verwendung in der Elektrotechnik und zur antistatischen Ausrüstung von Kunststoffen

Die Erfindung betrifft ein Verfahren zur Herstellung von
elektrisch leitfähigen Polymeren mit elektrischen Leitfähigkeitswerten größer als $10^{-2}$ S/cm und deren Verwendung in der
Elektroindustrie zur Herstellung von Sonnenzellen, zur
Umwandlung und Fixierung von Strahlung und zur Herstellung
elektrischer und magnetischer Schalter sowie zur antistatischen Ausrüstung von Kunststoffen.

Es ist bereits bekannt, organische Polymere aus der Reihe
der Polyphenylene durch oxidative Kupplung entsprechend
der Literatur: "Macromolecular Syntheses Collective", 1,
(1979), Seiten 109 bis 110 und "Naturwiss." 56 (1969),
Seiten 308 bis 313, herzustellen. Außerdem ist die Herstellung von Polyphenylenen durch stufenweise Polykondensation nach R. Gehm und W. Kern aus "Makromolekulare
Chemie" 7 (1951), Seiten 46 bis 61, bekannt, wobei besonders einheitliche para-verkettete methylsubstituierte
Derivate erhalten werden, die nicht zusätzlich durch
ortho- oder meta-verknüpfte Polymere verunreinigt sind.
Die organischen Polymeren aus der Reihe der Heteropolyphenylene unterscheiden sich von den Polyphenylenen durch
das Vorhandensein von Heteroatomen oder Heteroatome enthaltenden Gruppen zwischen den aromatischen Ringsystemen.
Diese Polymeren sind z.B. beschrieben in "Macromolecular
Synthesis", 6, (1978), Seiten 45 bis 48. Auch die Herstellung der organischen Polymere aus der Reihe der Polyacetylene durch Polymerisation von Acetylen ist bekannt.
Sie ist z.B. in den Arbeiten von Hatano in "J. Chem. Soc.
Japan, Ind. Chem. Sect." 65, (1962), Seite 723 ff. sowie
von D.J. Berets et al. "Trans. Farad. Soc." 64, (1968),
Seite 823 ff. beschrieben. Auch in neueren Publikationen

Fre/BL

von H. Shirakawa et al., "J. Chem. Soc., Chem. Comn." 1977, Seiten 578 bis 580 ist die Polymerisation von Acetylen zu Polyacetylen mit Hilfe von Ziegler-Katalysatoren beschrieben. Nach den genannten Methoden werden Produkte erhalten, die in den üblichen Lösungsmitteln vollkommen unlöslich sind und als schwarze amorphe bis teilkristalline Materialien anfallen. Auch die in den "Ber. Bunsenges. Phys. Chem." 68, (1964), Seiten 558 bis 567 erhaltenen Materialien werden mit umfaßt.

Der Erfindung lag die Aufgabe zugrunde, die an sich bekannten organischen Polymeren aus der Reihe der Polyphenylene, Heteropolyphenylene oder Polyacetylene durch Zusätze in elektrisch leitfähige Polymere mit elektrischen Leitfähigkeitswerten größer als $10^{-2}$ S/cm umzuwandeln und darüber hinaus entscheidend gegen oxidative Schädigung zu stabilisieren und die Verarbeitbarkeit und Anwendungsbreite deutlich zu erhöhen.

Diese Aufgabe wird erfindungsgemäß dadurch gelöst, daß man den organischen Polymeren aus der Reihe der Polyphenylene, Heteropolyphenylene oder Polyacetylene unter Ausschluß von Wasserfeuchtigkeit und von Sauerstoff 0,1 bis 95 Gew.%, bezogen auf das Polymere, schwarzem Phosphor und 0,5 bis 25 Gew.%, bezogen auf das eingesetzte organische Polymere, einer starken Lewis-Säure mit $pk_s$-Werten von -10 bis +14 zusetzt. Nach bevorzugter Verfahrensweise wird als Lewis-Säure die Verbindung $AsF_5$, $SbF_5$, $UF_6$, $SbCl_5$, $AlCl_3$, $BF_3$, $CF_3SO_3H$, $VOCl_3$, $HClO_4$, $NO^+SbF_6^-$, $NO_2^+SbF_6^-$, $NO^+AsF_6^-$, $NO^+PF_6^-$, $J_2$, $Br_2$, $JCl$, $PF_5$, $CrO_2Cl_2$, $NO_2^+PF_6^-$, $NO^+BF_4^-$, $NO^+ClO_4^-$, $(CF_3)_2SO_4$, $NbF_5$, $TaF_5$, $WF_6$, $FeCl_3$, $CdCl_2$, 2,4,6-Trinitrophenol, 2,4,6-Trinitrophenylsulfonsäure oder 2,4,6-Trinitrophenylcarbonsäure zugesetzt.

0044935

Die elektrischen Leitfähigkeitswerte werden in S/cm bei 30°C gemessen, die Messung selbst erfolgt nach der Methode von F. Beck, "Berichte Bunsengesellschaft, Physikalische Chemie" 68 (1964), Seiten 558 bis 567. Die elektrische Leitfähigkeitswerte der erfindungsgemäßen leitfähigen Polymeren ist größer als $10^{-2}$ S/cm.

Nach dem erfindungsgemäßen Verfahren wird den organischen Polymeren unter Ausschluß von Wasserfeuchtigkeit und von Sauerstoff, 0,1 bis 95 Gew.%, bezogen auf das Gewicht des Polymeren, schwarzem Phosphor und 0,5 bis 5 Gew.%, bezogen auf das eingesetzte Polyphenylen, einer starken Lewis-Säure mit $pk_s$-Werten von -10 bis +4 zugesetzt.

Das Einarbeiten der Zusätze erfolgt unter Ausschluß von Feuchtigkeit (Wasser) sowie Sauerstoff (Luft), es wird daher vorzugsweise unter Edelgas-Argonatmosphäre gearbeitet. Gegebenenfalls werden Hilfsflüssigkeiten wie Tetrahydrofuran, Dimethoxyglykol, Nitromethan oder Methylenchlorid eingesetzt, die nach dem Einarbeiten bei Temperaturen unter 30°C in Vakuum abgezogen werden.

Durch die genannten Zusätze können elektrische Leitfähigkeitsanstiege von einigen Größenordnungen erreicht werden. Die Ausgangsleitfähigkeit der organischen Polymeren betrugen $10^{-12}$ S/cm. Die erfindungsgemäßen organischen Polymeren haben Ausgangsleitfähigkeiten von weniger als $10^{-12}$ S/cm, liefern aber nach der Zugabe der erfindungsgemäßen Zusätze Leitfähigkeiten größer als $10^{-2}$ S/cm.

Die erfindungsgemäß hergestellten elektrisch leitfähigen polymeren Systeme mit elektrischen Leitfähigkeiten größer als $10^{-2}$ S/cm sind zur antistatischen Ausrüstung von Kunststoffen, zur Herstellung von Sonnenzellen, zur Umwandlung und Fixierung von Strahlung sowie zur Herstellung elektrischer und magnetischer Schalter geeignet. Durch die Zusätze der starken Lewis-Säure mit schwarzem Phosphor entstehen sog. p-Leiter (vgl. "J. Chem. Education", 46, (1969), Nr. 2, Seite 82).

Die in den folgenden Beispielen genannten Teile sind Gewichtsteile bzw. Molprozente.

Beispiele 1 bis 7

10 Teile eines organischen Polymeren werden unter Argonatmosphäre und Ausschluß von Feuchtigkeit mit dem jeweiligen Zusatzstoff versetzt, die Messung der elektrischen Leitfähigkeit erfolgt nach F. Beck "Ber. Bunsenges. Phys. Chem." 68, (1964), Seiten 558 bis 567.

Tabelle

| Beispiel Nr. | organ. Polymeres Teile | P schwarz Teile | Zusatzstoff Art und Menge in Mol.% | Leitfähigkeit S/cm 30°C vor dem Zusatz | Leitfähigkeit S/cm 30°C nach dem Zusatz |
|---|---|---|---|---|---|
| 1 | Polyacetylen nach Shirakawa 1) | 10 | 1 | $AsF_5$ 0,2 | $10^{-10}$ | $8,6 \cdot 10^{+2}$ |
| 2 | " | | 0,5 | $I_2$ 0,2 | $10^{-10}$ | $4,9 \cdot 10^{+2}$ |
| 3 | " | | 2 | $I_2$ 0,2 | $10^{-10}$ | $6,4 \cdot 10^{+2}$ |
| 4 | " | | 2 | $NO^+PF_6$ 0,2 | $10^{-10}$ | $6,9 \cdot 10^{+2}$ |
| 5 | " | | 10 | $CF_3COOH$ 0,2 | $10^{-10}$ | $3,8 \cdot 10^{+2}$ |
| 6 | " | | 10 | $SbF_5$ 0,2 | $10^{-10}$ | $9,5 \cdot 10^{+2}$ |
| 7 | Polyacetylen nach Lüttinger 2) | | 1 | $HClO_4$ 0,3 | $10^{-10}$ | $3,2 \cdot 10^{+1}$ |
| 8 | Polyacetylen nach Shirakawa 1) | | 1 | $NbF_5$ 0,3 | $10^{-10}$ | $4,5 \cdot 10^{+1}$ |
| 9 | " | | 1 | $WF_6$ 0,3 | $10^{-10}$ | $2,1 \cdot 10^{+1}$ |
| 10 | " | | 1 | $HCl_3$ 0,3 | $10^{-10}$ | $5,0 \cdot 10^{+2}$ |
| 11 | " | | 1 | $H_2SO_4$ 0,3 | $10^{-10}$ | $3,8 \cdot 10^{+1}$ |

1) J. Chem. Soc., Chem. Commn. 1977, 578 ff.
2) J. Org. Chem. 29 (1964) 2936 ff.

BAD ORIGINAL

## Patentansprüche

1. Verfahren zur Herstellung von elektrisch leitfähigen Polymeren mit elektrischen Leitfähigkeitswerten größer als $10^{-2}$ S/cm, <u>dadurch gekennzeichnet</u>, daß man organischen Polymeren aus der Reihe der Polyphenylene, Heteropolyphenylene oder vorzugsweise Polyacetylene unter Ausschluß von Wasserfeuchtigkeit und von Sauerstoff schwarzen Phosphor in Mengen von 0,1 bis 95 Gew.%, bezogen auf das Polymere, und 0,5 bis 25 Gew.%, bezogen auf das Polymere, einer starken Lewis-Säure mit $pk_S$-Werten von -10 bis +4 zusetzt.

2. Verfahren nach Anspruch 1, <u>dadurch gekennzeichnet</u>, daß als Lewis-Säure die Verbindung $AsF_5$, $SbF_5$, $UF_6$, $SbCl_5$, $AlCl_3$, $BF_3$, $CF_3SO_3H$, $VOCl_3$, $HClO_4$, $NO^+SbF_6^-$, $NO_2^+SbF_6^-$, $NO^+AsF_6^-$, $NO^+PF_6^-$, $J_2$, $Br_2$, $JCl$, $PF_5$, $CrO_2Cl_2$, $NO_2^+PF_6^-$, $NO^+BF_4^-$, $NO^+ClO_4^-$, $(CF_3)_2SO_4$, $NbF_5$, $TaF_5$, $WF_6$, $FeCl_3$, $CdCl_2$, 2,4,6-Trinitrophenol, 2,4,6-Trinitrophenylsulfonsäure oder 2,4,6-Trinitrophenylcarbonsäure zugesetzt wird.

3. Verwendung der nach Anspruch 1 hergestellten, elektrisch leitfähigen Polymeren in der Elektrotechnik zur Herstellung von Sonnenzellen, zur Umwandlung und Fixierung von Strahlung und zur Herstellung elektrischer und magnetischer Schalter.

4. Verwendung der nach Anspruch 1 hergestellten, elektrisch leitfähigen Polymeren zur antistatischen Ausrüstung von Kunststoffen.

**Europäisches Patentamt**

**EUROPÄISCHER RECHERCHENBERICHT**

0044935

Nummer der Anmeldung

EP 81104592.1

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| P | EP - A1 - 0 023 596 (BASF) (11-02-1981) <br> * Ansprüche * <br> & DE-A1-2 929 366 (12-02-1981) <br> -- | 1-4 |
| P | EP - A1 - 0 016 305 (ALL. CHEM. CORPORATION) (01-10-1980) <br> * Ansprüche * <br> -- | 1-4 |
| A | US - A - 4 204 216 (HEEGER) <br> * Zusammenfassung * <br> -- | 1 |
| A | CH - A - 444 314 (BASF) <br> * Spalte 2, Zeile 1 - Spalte 3, Zeile 41 * <br> & GB-A-1 000 679 <br> ---- | 1,2 |

**KLASSIFIKATION DER ANMELDUNG (Int. Cl.³)**

C 08 L 65/00

H 01 B 1/12

H 01 L 31/02

**RECHERCHIERTE SACHGEBIETE (Int. Cl.³)**

C 08 L 65/00

C 08 L 49/00

C 08 G 61/00

C 08 K 3/00

C 08 K 5/00

H 01 B 1/00

H 01 L 31/00

H 01 L 29/00

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

| X | Der vorliegende Recherchenbericht wurde für alle Patentansprüche erstellt. |
|---|---|

| Recherchenort | Abschlußdatum der Recherche | Prüfer |
|---|---|---|
| WIEN | 02-10-1981 | KUTZELNIGG |

EPA form 1503.1 06.78